# EUROPÄISCHE PATENTSCHRIFT

(11) **EP 2 729 969 B1**
(45) Veröffentlichungstag und Bekanntmachung des Hinweises auf die Patenterteilung: **02.11.2016**
(21) Anmeldenummer: 12737485.8
(22) Anmeldetag: 04.07.2012
(51) Int. Cl.: H01L 39/14, H01L 39/16, H01L 39/24, H01B 12/06

(54) **ISOLIERTER HOCHTEMPERATUR-BANDSUPRALEITER UND VERFAHREN ZU SEINER HERSTELLUNG**
INSULATED HIGH-TEMPERATURE WIRE SUPERCONDUCTOR AND METHOD FOR PRODUCING SAME
RUBAN SUPRACONDUCTEUR À HAUTE TEMPÉRATURE ISOLÉ ET PROCÉDÉ DE FABRICATION DUDIT RUBAN SUPRACONDUCTEUR À HAUTE TEMPÉRATURE ISOLÉ

(30) Priorität: 06.07.2011 DE 102011107313
(43) Veröffentlichungstag der Anmeldung: 14.05.2014
(73) Patentinhaber: Karlsruher Institut Für Technologie (KIT), 76131 Karlsruhe (DE)
(72) Erfinder: GOLDACKER, Wilfried, 69121 Heidelberg (DE); FINK, Stefan, 77656 Offenburg (DE); KUDYMOW, Andrej, 76297 Stutensee-Spöck (DE); ELSCHNER, Steffen, 69121 Heidelberg (DE); BRAND, Jörg, 68794 Oberhausen-Rheinhausen (DE)
(86) Internationale Anmeldenummer: PCT/EP2012/002847
(87) Internationale Veröffentlichungsnummer: WO 2013/004392

(56) Entgegenhaltungen:
- EP-A1- 0 807 939
- EP-A2- 1 075 030
- DE-A1- 19 755 445
- DE-B3-102006 032 702

## Beschreibung

Die Erfindung betrifft einen isolierten Hochtemperatur-Bandsupraleiter und ein Verfahren zu seiner Herstellung.

Supraleiter sind Materialien, die unterhalb einer *kritischen Temperatur* T_{c} keinen messbaren Widerstand aufweisen. Supraleitende Materialien besitzen außerdem einen *kritischen Strom* I*_{c}*, oberhalb dessen das Material normalleitend und unterhalb dessen das Material supraleitend ist. I_{c} hängt von der Temperatur und dem externen magnetischen Feld ab.

Materialien mit einer *kritischen Temperatur* > 20 K werden als Hochtemperatur-Supraleiter (HTS) bezeichnet. Wegen des dünnen Aufbaus sind *Hochtemperatur-Supraleiter der 2. Generation* (2G HTS) für diese Isolierung besonderes geeignet. Diese weisen supraleitende Schichten mit eine Dicke von 1-10 µm auf, bevorzugt aus Yttrium-Barium-Kupferoxid (YBCO), die auf ein 10-200 µm dickes, elektrisch leitfähiges Substrat, insbesondere aus einer Nickel-Chrom-Molybdän-Legierung, bekannt als *Hastelloy C276,* oder aus einer Nickel-Wolfram-Legierung, aufgebracht sind. Die Fa. SuperPower Inc., zeigt den Aufbau eines 2G HTS-Bands auf seiner Internet-Seite http://www.superpower-inc.com/content/2g-hts-wire.

In den supraleitenden Komponenten resistiver Strombegrenzer erfolgt die Anordnung der Hochtemperatur-Bandsupraleiter der 2. Generation typischerweise in flachen bifilaren *pancake* Spiralen, wie von W. Schmidt und H.-P. Krämer im IV. Braunschweiger Seminar für Hochtemperatursupraleiter-Anwendungen, 2009, vorgetragen; siehe Seite 12 des Vortrags unter http://www.tu-braunschweig.de/Medien-DB/iot/8-supraleitende-strombegrenzer-aus-ybco-bandleitern-h-p-kraemer.pdf Bei einer Konzipierung der Isolation dieser bifilaren Spiralen sind die folgenden physikalischen Effekte zu beachten:
- Bei Stromfluss durch Windungen der Spiralen wirken Lorentz-Kräfte, die in radialer Richtung symmetrierend wirken. In axialer Richtung wirken unvermeidbare kleinste Asymmetrien im Aufbau der Spirale jedoch destabilisierend (Kraftwirkung bei benachbarten Leitern in entgegengesetzte axiale Richtung), wobei gilt: Je größer die Asymmetrie, desto größer die Kraft.
- Beim Einsatz einer Wechselfrequenz vibriert der Leiter mit der doppelten Frequenz, d.h. bei einer angelegten Netzfrequenz von 50 Hz treten 100 Hz-Vibrationen im Leiter auf.
- Beim Quenchen im Stickstoffbad wirken zusätzlich Gasbildung und Druckaufbau auf den Leiter. Beim Verdampfen von flüssigem Stickstoff entsteht das ca. 700-fache Volumen an Gas, d.h. die unter die Isolierung eingedrungene Flüssigkeit kann beim Quenchen die Isolierung aufblasen und schädigen.

In bifilaren Spiralen ist eine Hochspannungsisolierung mit einer den Spannungsangaben angepassten Nutzdicke erforderlich. Bekannte Isolationsverfahren für die Hochtemperatursupraleiter sind Umwicklung, Lackierung oder Koextrusion, die jedoch insgesamt Probleme mit der scharfen Kante des 2G HTS aufweisen. Aufgrund der genannten 100 Hz-Vibrationen bewirken scharfe Kanten die Gefahr des Aufscheuerns mit Beschädigung der dünnen Isolationsschicht im Bereich der Kante.

Umwicklungen sind wegen des scharfen Knicks an der Kante eines Bands nur mit sehr dünnen Isolationslagen möglich. Überlappungen sind unvermeidlich, wodurch ein Leiter mit unregelmäßiger Dicke erhalten wird. Dies zeigt sich beispielhaft auf dem Datenblatt *Amperium Wire Insulation* (09/2010) der Fa. American Superconductor, das im Internet erhältlich ist unter
http://www.amsc.com/products/htswire/InsulatedWire.html.

Auch eine Isolierung durch Lackierung ist schwierig herzustellen, da z.B. bei einem 100 µm dicken Leiter eine 100 µm dicke Lack-Schicht nicht realisierbar ist.

Koextrusion für Hochtemperatur-Supraleiter ist bekannt aus WO 01/61712 A1 und WO 03/073439 A1.

Weitere Vorrichtungen und Verfahren sind aus EP 1 075 030 A2, DE 197 55 445 A1, DE 10 2006 032 702 B3 und EP 0 807 939 A1 bekannt.

Die Aufgabe der vorliegenden Erfindung besteht somit darin, die Nachteile und Einschränkungen des Stands der Technik zu überwinden. Insbesondere soll sich eine Isolierung für ein Band eines Hochtemperatur-Bandsupraleiters der 2. Generation aus einer einzigen, ausreichend dicken, glatten und homogenen Isolationsschicht herstellen lassen, die die notwendige Spannungsfestigkeit besitzt und die sich im Rahmen einer Qualitätskontrolle vor einer Auftragung auf ihre Hochspannungsfestigkeit in Bezug auf Risse, Poren, Defekte durch Fremdeinschlusse testen lässt. Mit einer derartigen Isolierung sollten die Ränder (Kanten) des Hochtemperatur-Bandsupraleiters besser geschützt werden, insbesondere sollten sie nicht direkt den genannten axialen Lorentz-Kräften ausgesetzt sein.

Diese Aufgabe wird im Hinblick auf den isolierten Hochtemperatur-Bandsupraleiter durch die Merkmale des Anspruchs 1 und im Hinblick auf ein Verfahren zu seiner Herstellung durch den Schritt des Anspruchs 6 gelöst.

Erfindungsgemäß weist ein isolierter Hochtemperatur-Bandsupraleiter ein Band aus einem nicht isolierten Hochtemperatur-Bandsupraleiter auf, dessen Breite mindestens das 10-fache seiner Dicke beträgt und worin ein Hochtemperatur-Supraleiter in eine Matrix eingebracht oder auf ein Substrat aufgebracht ist, das beidseitig mit einer elektrisch nicht leitenden Isolationsschicht, bevorzugt einer polymeren Folie, besonders bevorzugt aus Polyinmid versehen, vorzugsweise laminiert, ist.

Im Folgenden bezeichnen:
- *B*: Breite des isolierten Hochtemperatur-Bandsupraleiters;
- *D*: Dicke des isolierten Hochtemperatur-Bandsupraleiters;
- *b*: Breite des Bands aus dem nicht isolierten Hochtemperatur-Bandsupraleiter; und
- *d*: Dicke des Bands aus dem nicht isolierten Hochtemperatur-Bandsupraleiter.

Die beiden Isolationsschichten sind derart auf das Band aus dem nicht isolierten Hochtemperatur-Bandsupraleiter aufgebracht, dass bei geforderter Hochspannungsfestigkeit die in Bezug auf das Band überstehende Isolationsrandbreite *(B-b)* ausreicht, um einen Überschlag über einen Kriechweg auszuschließen, und zwar auch dann noch, wenn die Verklebung des Überstandes durch Gasentwicklung geschädigt oder völlig gelöst sein sollte.

In einer besonders bevorzugten Ausgestaltung sind die beiden Isolationsschichten derart auf das Band aus dem nicht isolierten Hochtemperatur-Bandsupraleiter aufgebracht, dass bei geforderter Hochspannungsfestigkeit
- die Dicke der beiden Isolationsschichten *(D-d)* zwischen zwei benachbarten Bändern ausreicht, damit kein Durchschlag durch zwei benachbarten Isolationsschichten auftritt;
- die Adhäsion (Verklebung) zwischen der Isolationsschicht und dem Band so gewählt ist, dass weder das Band noch die Isolationsschicht durch die Ablösung der Isolierung durch ein Quenchen degradieren kann; und
- die überstehenden doppelten Isolationsränder in der Lage sind, die oben genannten Lorentz-Kräfte sicher zu beherrschen.

In einer besonders bevorzugten Ausgestaltung nimmt die gemeinsame Dicke *(D-d)* der beiden Isolationsschichten (2, 2') einen Wert im Bereich von 20 µm bis 2 mm an.

Die die in Bezug auf das Band überstehende Isolationsrandbreite *(B-b)* von 2 mm bis 200 mm, bevorzugt von 2 mm bis 40 mm, kann in Bezug auf das Band symmetrisch, d.h. gleich breit auf jeder Seite, oder asymmetrisch, d.h. unterschiedlich breit auf jeder Seite, sein. In einer besonders bevorzugten Ausgestaltung ist die die in Bezug auf das Band überstehende Isolationsrandbreite symmetrisch in Bezug auf das Band und die Größe *(B-b)*/*2* weist auf jeder Seite einen Wert im Bereich von 1 mm bis 100 mm, bevorzugt von 1 bis 20 mm auf.

Die vorliegende Erfindung betrifft weiterhin ein Verfahren zur Herstellung des erfindungsgemäßen isolierten Hochtemperatur-Bandsupraleiters. Hierzu wird jeweils eine elektrisch nicht leitende Isolationsschicht auf beide Seiten eines Bands aus einem nicht isolierten Hochtemperatur-Bandsupraleiters aufgebracht, dessen Breite mindestens das 10-fache seiner Dicke beträgt und worin ein Hochtemperatur-Supraleiter in eine Matrix eingebracht oder auf ein Substrat aufgebracht ist.

In einer erfindungsgemäßen Ausgestaltung wird eine Isolationsschicht auf eine Seite des Bands oder jeweils eine Isolationsschicht auf jede Seite des Bands auflaminiert. In einer bevorzugten Ausgestaltung erfolgt das Laminieren mit einem Heißkleber oder einem Heißsiegelkleber bei einer Reaktionstemperatur im Bereich von 100 °C bis 250 °C, die jeweils auf die dem Band zugewandten Seite der mindestens einen Isolationsschicht als Schicht aufgebracht wird.

Die vorliegende Erfindung weist insbesondere die folgenden Vorteile und besonderen Wirkungen auf.
- Die erfindungsgemäß isolierten Hochtemperatur-Bandsupraleiter sind ausreichend gegen Durchschlag und gegen Überschlag gesichert;
- die empfindlichen Oberflächen des Bands sind jeweils mit einer Isolationsschicht versiegelt und gegen Abscheuern sowohl am Rande als auch auf der Fläche geschützt;
- die Laminierung trägt homogen auf und fängt daher etwaige Kräfte in axialer Richtung besser ab;
- im Unterschied zur Isolations-Bewicklung ist es möglich, mit nur einer einzigen Isolationsschicht pro Fläche eine genügend hohe Isolierung zu erhalten;
- anders als bei Umwicklungen treten hier keine mechanischen Restspannungen auf, die den Leiter verformen können;
- eine Laminierung ist gegenüber einer Koextrusion weniger aufwändig und lässt sich einfacher auch bei dünnen scharfkantigen Bändern aufbringen.

In bestimmten Anwendungen wie z.B. in Zwillingsanodnung ist eine Isolation nur in einer Richtung erforderlich. Deshalb müssen die auf beiden Seiten des Bands aufgebrachten Folien hier nicht identisch sein, insbesondere nicht bzgl. ihres Materials und ihrer Dicke.

In einer besonderen Ausgestaltung haftet die Isolationsschicht nicht auf dem Band. In diesem Fall genügt es, nur eine der beiden Folien mit einer Schicht aus einem Kleber zu belegen.

Erfindungsgemäß lässt sich auch ein Band aus einem nicht isolierten Hochtemperatur-Bandsupraleiter der 1. Generation einsetzen, das eine wesentlich höherer Dicke aufweist. In dieser Ausgestaltung sind die Isolationsschichten bevorzugt mit einer für den Leiter vorgesehenen Nut vorstrukturiert.

Die Erfindung wird im Folgenden anhand eines Ausführungsbeispiels und den Figuren näher erläutert. Hierbei zeigen im Einzelnen:
- **Fig. 1**: Schematische Darstellung eines isolierten Hochtemperatur-Bandsupraleiters;
- **Fig. 2**: Querschnitt durch einen isolierten Hochtemperatur-Bandsupraleiter;
- **Fig. 3**: Querschnitt durch zwei aufeinander gelegte isolierte Hochtemperatur-Bandsupraleiter mit Darstellung eines Hochspannungs-Durchschlags;
- **Fig. 4**: Querschnitt durch zwei aufeinander gelegte isolierte Hochtemperatur-Bandsupraleiter mit Darstellung eines Kriechweg bei einem Überschlag.

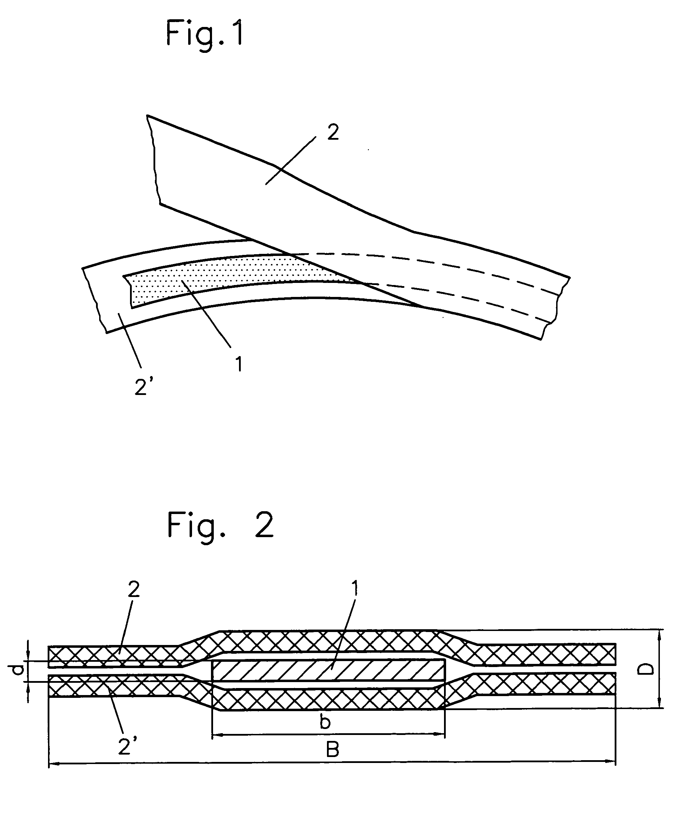

**Fig. 1** zeigt in schematischer Schrägaufsicht einen erfindungsgemäß isolierten Hochtemperatur-Bandsupraleiter, bei dem auf beide Seiten eines Bands (1) aus einem nicht isolierten Hoch-temperatur-Bandsupraleiter jeweils eine Isolationsschicht (2, 2') aufgebracht ist. Zur Illustration ist hierbei eine der beiden Isolationsschichten (2) ein Stück weit vom Band (1) abgelöst dargestellt.

Das eingesetzte Band (1) war 50-150 µm dick und wies eine 1-3 µm dünne Schicht aus supraleitendem Yttrium-Barium-Kupferoxid (YBCO) auf, die auf ein elektrisch leitfähiges Substrat aus der Nickel-Chrom-Molybdän-Legierung *Hastelloy C276* aufgebracht war. Als Isolationsschicht (2, 2') diente das Polymer Polyimid, das mit einem Polyesterharz-Heißsiegelkleber beschichtet war. Als Reaktionstemperatur für die Laminierung wurde ein Wert von ca. 130 °C gewählt.

**Fig. 2** zeigt einen Querschnitt durch einen isolierten Hochtemperatur-Bandsupraleiter. Das Band (1) aus dem nicht isolierten Hochtemperatur-Bandsupraleiter ist auf jeder seiner beiden Seiten mit einer Isolationsschicht (2, 2') in Form einer Folie versehen. Die Tatsache, dass dass hier mindestens eine der beiden Isolationsschichten (2, 2') auf der dem Band (1) zugewandten Seite mit einer Schicht aus einem Kleber belegt ist, ist aufgrund der geringen Dicke dieser Schicht nicht dargestellt.

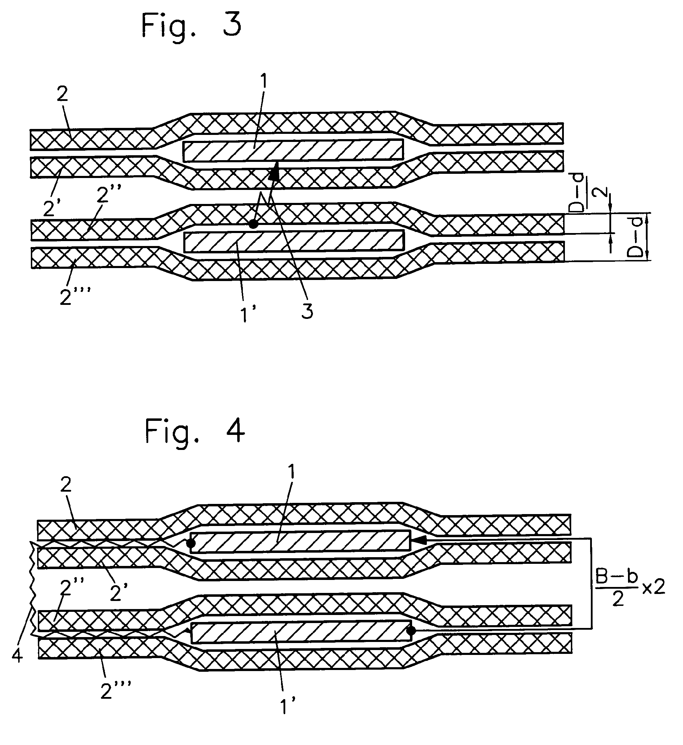

**Fig. 3** zeigt einen Querschnitt durch zwei aufeinander gelegte isolierte Hochtemperatur-Bandsupraleiter. Die gemeinsame Dicke *(D-d)* der beiden Isolationsschichten (2, 2') ist so gewählt, um einen Durchschlag (3) durch zwei benachbarte Isolationsschichten (2', 2'') bei der eingesetzten Hochspannung auszuschließen.

**Fig. 4** zeigt einen Querschnitt durch zwei aufeinander gelegte isolierte Hochtemperatur-Bandsupraleiter. Die in Bezug auf das Band (1) überstehende symmetrische Randbreite *(B-b)*/*2* jeder Isolationsschicht (2, 2') auf jeder der beiden Seiten betrug
4 mm. Dieser Wert wurde so gewählt, um einen Überschlag durch Ausbildung eines Kriechwegs (4) mit einer Länge *(B-b)* zwischen den beiden benachbarten Bändern (1, 1') auszuschließen, und zwar auch dann noch, wenn die Verklebung der überstehenden Randbreite durch Gasentwicklung geschädigt oder völlig gelöst sein sollte.

## Patentansprüche

1. Isolierter Hochtemperatur-Bandsupraleiter, umfassend ein Band (1) aus einem nicht isolierten Hochtemperatur-Bandsupraleiter, dessen Breite mindestens das 10-fache seiner Dicke beträgt und worin ein Hochtemperatur-Supraleiter in eine Matrix eingebracht oder auf ein Substrat aufgebracht ist, wobei das Band (1) derart beidseitig jeweils mit einer elektrisch nicht leitenden Isolationsschicht (2, 2') jeweils in Form einer direkt auf den nicht isolierten Hochtemperatur-Bandsupraleiter aufgebrachten Folie versehen ist, dass die beiden Isolationsschichten (2, 2') eine in Bezug auf das Band (1, 1') überstehende Isolationsrandbreite aufweisen, die einen Wert von 2 mm bis 200 mm annimmt und mindestens eine der beiden Isolationsschichten (2, 2') auf eine Seite des Bands (1) auflaminiert ist.

2. Isolierter Höchtemperatur-Bandsupraleiter nach Anspruch 1, **dadurch gekennzeichnet, dass** die beiden Isolationsschichten (2, 2') eine gemeinsame Dicke von 20 µm bis 2 mm aufweisen.

3. Isolierter Hochtemperatur-Bandsupraleiter nach Anspruch 1 oder 2, **dadurch gekennzeichnet, dass** mindestens eine der beiden Isolationsschichten (2, 2') auf der dem Band (1) zugewandten Seite mit einer Schicht aus einem Kleber belegt ist.

4. Isolierter Hochtemperatur-Bandsupraleiter nach einem der Ansprüche 1 bis 3, **dadurch gekennzeichnet, dass** mindestens eine der beiden Isolationsschichten (2, 2') aus mindestens einem Polymer besteht.

5. Isolierter Hochtemperatur-Bandsupraleiter nach Anspruch 4, **dadurch gekennzeichnet, dass** mindestens eine der beiden Isolationsschichten (2, 2') aus Polyimid besteht.

6. Verfahren zur Herstellung eines isolierten Hochtemperatur-Bandsupraleiters nach einem der Ansprüche 1 bis 5, mit dem **Schritt:**
Aufbringen jeweils einer elektrisch nicht leitenden Isolationsschicht (2, 2') jeweils in Form einer Folie derart auf beide Seiten eines Bands (1) aus einem nicht isolierten Hochtemperatur-Bandsupraleiter, dessen Breite mindestens das 10-fache seiner Dicke beträgt und worin ein Hochtemperatur-Supraleiter in eine Matrix eingebracht oder auf ein Substrat aufgebracht ist, dass die beiden Isolationsschichten (2, 2') eine in Bezug auf das Band (1, 1') überstehende Isolationsrandbreite aufweisen, die einen Wert von 2 mm bis 200 mm annimmt, wobei die Isolationsschichten direkt auf den nicht isolierten Hochtemperatur-Bandsupraleiter aufgebracht sind und mindestens eine der beiden Isolationsschichten(2, 2') auf eine Seite des Bands (1) auflaminiert wird.

7. Verfahren nach Anspruch 6, wobei die Dicke der Isolationsschichten (2, 2') so gewählt wird, dass die gemeinsame Dicke von 20 µm bis 2 mm beträgt.

8. Verfahren nach Anspruch 6 oder 7, wobei das Auflaminieren mit einem Heißkleber oder einem Heißsiegelkleber bei einer Reaktionstemperatur im Bereich von 100 °C bis 250°C erfolgt, wozu die dem Band (1) zugewandten Seite der mindestens einen Isolationsschicht(2, 2') mit einer Schicht aus dem Heißkleber oder Heißsiegelkleber belegt wird.

9. Verfahren nach einem der Ansprüche 6 bis 8, wobei als Isolationsschicht (2, 2') eine Folie aus mindestens einem Polymer eingesetzt wird.

10. Verfahren nach Anspruch 9, wobei als Isolationsschicht (2, 2') eine Folie aus Polyimid eingesetzt wird.

## Claims

1. Insulated high-temperature wire superconductor, comprising a wire (1) of a non-insulated wire superconductor, the width of said superconductor being at least 10 times the thickness thereof, and wherein a high-temperature superconductor is introduced into a matrix or is applied onto a substrate, wherein the wire (1) is provided in each case on both sides with an electrically non-conducting insulating layer (2, 2'), in each case in the form of a film applied directly onto the non-insulated wire superconductor, and wherein the two insulating layers (2, 2') have an insulating edge width which projects in relation to the wire (1, 1') and which assumes a value of 2 mm to 200 mm, and at least one of the two insulating layers (2, 2') is laminated onto a side of the wire (1).

2. Insulated high-temperature wire superconductor according to claim 1, **characterised in that** the two insulating layers (2, 2') have a common thickness of 20 µm to 2 mm.

3. Insulated high-temperature wire superconductor according to claim 1 or 2, **characterised in that** at least one of the two insulating layers (2, 2') is coated with a layer of an adhesive on the side facing the wire (1).

4. Insulated high-temperature wire superconductor according to any one of claims 1 to 3, **characterised in that** at least one of the two insulating layers (2, 2') consists of at least one polymer.

5. Insulated high-temperature wire superconductor according to claim 4, **characterized in that** at least one of the two insulating layers (2, 2') consists of polyamide.

6. Method for producing an insulated high-temperature wire superconductor according to one of claims 1 to 5, with the step:
application in each case of an electrically non-conductive insulating layer (2, 2') in each case in the form of a film, in such a way on both sides of a wire (1) made of a non-insulating high-temperature wire superconductor, the width of said superconductor being at least 10 times the thickness thereof, and wherein a high-temperature superconductor is introduced into a matrix or is applied onto a substrate, and wherein the two insulating layers (2, 2') have an insulating edge width which projects in relation to the wire (1, 1') and which assumes a value of 2 mm to 200 mm, wherein the insulating layers (2, 2') are applied directly onto the non-insulating high-temperature wire superconductor, and at least one of the two insulating layers is laminated onto a side of the wire (1).

7. Method according to claim 6, wherein the thickness of the insulating layers (2, 2') is selected in such a way that the common thickness is 20 µm to 2 mm.

8. Method according to claim 6 or 7, wherein the laminating takes place with a hot adhesive or a hot-sealing adhesive, with a reaction temperature in the range from 100 °C to 250 °C, for which purpose the side facing the wire (1) of the at least one insulating layer (2, 2') is coated with a layer of the hot adhesive or hot-sealing adhesive.

9. Method according to one of claims 6 to 8, wherein, as the insulating layer (2, 2'), a film consisting of at least one polymer is used.

10. Method according to claim 9, wherein, as the insulating layer (2, 2'), a film of polyamide is used.

## Revendications

1. Elément à ruban supraconducteur à haute température isolé comprenant un ruban (1) en un supraconducteur à haute température non isolé dont la largeur est d'au moins dix fois son épaisseur, et, dans lequel un supraconducteur à haute température est incorporé dans une matrice ou appliqué sur un substrat, le ruban (1) étant respectivement équipé de chaque côté d'une couche d'isolation (2, 2') électriquement non conductrice respectivement sous la forme d'un film appliqué directement sur le ruban supraconducteur à haute température non isolé, de sorte que les deux couches d'isolation (2, 2') aient une largeur d'isolation de bord dépassant du ruban (1, 1') de 2 mm à 200 mm et au moins l'une des deux couches d'isolation (2, 2') étant stratifiée sur une face du ruban (1).

2. Elément à ruban supraconducteur à haute température isolé conforme à la revendication 1,
**caractérisé en ce que**
les deux couches d'isolation (2, 2') ont une épaisseur commune de 20 µm à 2 mm.

3. Elément à ruban supraconducteur à haute température isolé conforme à la revendication 1 ou 2
**caractérisé en ce qu'**
au moins l'une des deux couches d'isolation (2, 2') est garnie d'une couche d'adhésif sur sa face tournée vers le ruban (1).

4. Elément à ruban supraconducteur à haute température isolé, conforme à l'une des revendications 1 à 3,
**caractérisé en ce qu'**
au moins l'une des deux couches d'isolation (2, 2') est constituée d'au moins un polymère.

5. Elément à ruban supraconducteur à haute température isolé, conforme à la revendication 4,
**caractérisé en ce qu'**
au moins l'une des deux couches d'isolation (2, 2') est réalisée en polyimide.

6. Procédé de fabrication d'un élément à ruban supraconducteur à haute température isolé, conforme à l'une des revendications 1 à 5, comprenant des étapes consistant à :
- appliquer respectivement une couche d'isolation électriquement non conductrice (2, 2') respectivement sous la forme d'un film sur les deux faces d'un ruban (1) supraconducteur à haute température non isolé dont la largeur est au moins égale à dix fois son épaisseur, et dans lequel un supraconducteur à haute température est incorporé dans une matrice ou appliqué sur un substrat de sorte que les deux couches d'isolation (2, 2') aient une largeur d'isolation de bord dépassant du ruban (1, 1') de 2 mm à 200 mm, les couches d'isolation étant appliquées directement sur le ruban supraconducteur à haute température non isolé, et au moins l'une des deux couches d'isolation (2, 2') étant stratifiée sur une face du ruban (1).

7. Procédé conforme à la revendication 6,
selon lequel
l'épaisseur des couches d'isolation (2, 2') est choisie de sorte que l'épaisseur commune soit de 20 µm à 2 mm.

8. Procédé conforme à la revendication 6 ou 7,
selon lequel
la stratification est effectuée à l'aide d'un adhésif à chaud ou d'un adhésif de thermosoudage à une température réactionnelle située dans la plage de 100°C à 250°C, la face de la couche d'isolation (2, 2') tournée vers le ruban (1) étant garnie d'une couche de l'adhésif à chaud ou de l'adhésif de thermosoudage.

9. Procédé conforme à l'une des revendications 6 à 8,
selon lequel
en tant que couche d'isolation (2, 2'), on utilise un film en au moins un polymère.

10. Procédé conforme à la revendication 9,
selon lequel
en tant que couche d'isolation (2, 2'), on utilise un film en polyimide.
